# EUROPÄISCHE PATENTSCHRIFT

(11) **EP 4 533 114 B1**
(45) Veröffentlichungstag und Bekanntmachung des Hinweises auf die Patenterteilung: **07.10.2026**
(21) Anmeldenummer: 23727553.2
(22) Anmeldetag: 17.05.2023
(51) Int. Cl.: G01R 33/32, G01R 33/26

(54) **AUTOMATISIERTE RESONANZREGELUNG FÜR NV-MAGNETOMETER**
AUTOMATED RESONANCE CONTROL FOR NV MAGNETOMETERS
COMMANDE DE RÉSONANCE AUTOMATISÉE POUR MAGNÉTOMÈTRES NV

(30) Priorität: 31.05.2022 DE 102022113754
(43) Veröffentlichungstag der Anmeldung: 09.04.2025
(73) Patentinhaber: Quantum Brilliance GmbH, 70565 Stuttgart (DE)
(72) Erfinder: SCHILLER, Ferdinand, 70825 Korntal-Muenchingen (DE); ROELVER, Robert, 75365 Calw (DE); JAG-LAUBER, Katharina, 73650 Winterbach (DE)
(74) Vertreter: DREISS Patentanwälte PartG mbB
(86) Internationale Anmeldenummer: PCT/EP2023/063409
(87) Internationale Veröffentlichungsnummer: WO 2023/232491

(56) Entgegenhaltungen:
- US-B2- 10 712 408
- FESCENKO ILJA ET AL: "Diamond magnetometer enhanced by ferrite flux concentrators", PHYSICAL REVIEW RESEARCH, vol. 2, no. 2, 24 June 2020 (2020-06-24), XP055936990, DOI: 10.1103/PhysRevResearch.2.023394
- HANNAH CLEVENSON ET AL: "Robust High-Dynamic-Range Vector Magnetometry via Nitrogen-Vacancy Centers in Diamond", ARXIV.ORG, CORNELL UNIVERSITY LIBRARY, 201 OLIN LIBRARY CORNELL UNIVERSITY ITHACA, NY 14853, 27 February 2018 (2018-02-27), XP081134649, DOI: 10.1063/1.5034216

## Beschreibung

### Gebiet der Erfindung

Die Erfindung betrifft ein Verfahren zur Bestimmung eines äußeren Magnetfeldes mit einem NV-Magnetometer mit automatisierter Resonanzregelung, sowie ein solches NV-Magnetometer und die Verwendung eines oder mehrerer solcher NV-Magnetometer für gradiometrische Messungen.

### Hintergrund der Erfindung

Das Stickstoff-Fehlstellen-Zentrum ist einer von über 100 bekannten Defekten im Diamantgitter. Bei diesen Defekten handelt es sich um Verunreinigungen des reinen Kohlenstoffgitters des Diamanten. Das Stickstoff-Fehlstellenzentrum wird auch als NV-Zentrum bezeichnet. Quantensensoren wie beispielsweise NV-Magnetometer machen sich die extreme Empfindlichkeit von Quantensystemen gegenüber ihrer Umgebung zunutze und ermöglichen deutliche verbesserter Sensoren. Durch das Einfangen eines zusätzlichen Elektrons bilden NV-Zentren über den Spin des Elektrons einen mikroskopischen Kompass. Durch präzise Manipulation und Messung des Zustands dieses NV-Spins lassen sich kleinste Veränderungen im umgebenden Magnetfeld messen. Diese Technik wird NV-Magnetometrie genannt und beruht auf der Wechselwirkung zwischen dem NV-Zentrum und dem umgebenden Magnetfeld. Das Vorhandensein eines Magnetfeldes äußert sich in einer Änderung der Energien der Spinzustände des NV-Zentrums. Die Auswirkung des Magnetfeldes lässt sich leicht an der Veränderung des Mikrowellenanregungsspektrums des NV-Zentrums erkennen.

Ein entscheidender Vorteil der NV-Magnetometrie ergibt sich aus dem gut verstandenen Verhalten der NV-Zentrumspinübergangsfrequenzen, die eindeutige Informationen über die Stärke und die Richtung des Magnetfelds liefern. Diese Fähigkeit, selbstkalibrierte, quantitative Daten zu liefern, kombiniert mit einer sehr hohen Reproduzierbarkeit (jedes NV-Zentrum ist gleich) sind wesentliche Eigenschaften von NV-Magnetometern. Ein großer Vorteil von NV-Magnetometern ist ihre große Empfindlichkeit gegenüber kleinen Signalen. Die Empfindlichkeit eines NV-Magnetometers für magnetische Gleichfelder hängt insbesondere von der Dichte der NV-Zentren im Diamantchip, von der Quantenkohärenz der NV-Zentren und von der Effizienz der optischen Auslesung ab. Bei Magnetfeld-, Temperatur- und/oder Druckänderungen verschieben sich die Magnetresonanzen des NV-Zentrum-Grundzustandes, welche für die Magnetfeldmessung des NV-Magnetometers genutzt werden. Dies führt zu einem eingeschränkten Dynamikbereich des NV-Magnetometers und zu einem schlechteren Signal-zu-Rausch Verhältnis (SNR).

Der Artikel von H.Clevenson etal. in Appl.Phys.Lett 112, 252406 (2018) offenbart ein robustes, skalenfaktorfreies Vektormagnetometer, das ein Frequenzverriegelungsschema mit geschlossenem Regelkreis verwendet, um gleichzeitig Zeeman-gespaltene Resonanzpaare von Stickstoff-Fehlstellenzentren (NV-Zentren) in Diamant zu verfolgen. Dennoch wäre eine noch weitere Erhöhung des Dynamikbereichs und der Bandbreite des NV-Magnetometers bezüglich der erfassbaren Magnetfeldänderungen sowie ein besseres SNR bei den Messungen sowie die Ermöglichung einer Erweiterung auf gradiometrische Magnetfeldmessungen bei gleichzeitiger Unterdrückung von Temperatur- und Druckschwankungen wünschenswert.

In dem Artikel "Diamond magnetometer enhanced by ferrite flux concentrators", Fescenko llja et al., Physical Review Research, Bd. 2, Nr. 2, 1. Juni 2020 wird eine NVdotierte Diamantmembran zwischen zwei Ferritkegeln in einer Bowtie-Konfiguration beschrieben.

In dem Artikel "Robust High-Dynamic-Range Vector Magnetometry via Nitrogen-Vacancy Centers in Diamond", Hannah Clevenson et al., arxiv.org, Cornell University Library, 201 Olin Library Cornell University Ithaca, NY 14853, 27. Februar 2018 wird eine direkte Erfassung der Resonanzfrequenzen von NV-Zentren, die entlang jeder der vier tetraedrischen kristallographischen Achsen des Diamanten ausgerichtet sind, sowie eine vollständige Vektorrekonstruktion eines angelegten Magnetfelds beschreiben.

### Zusammenfassung der Erfindung

Der Erfindung liegt die Aufgabe zugrunde, eine NV-Magnetometer bereitzustellen, das einen erhöhten Dynamikbereich und eine höhere Bandbreite bezüglich der erfassbaren Magnetfeldänderungen sowie ein besseres SNR bei den Messungen ermöglicht.

Die Aufgabe wird gelöst durch ein Verfahren zur Bestimmung eines äußeren Magnetfeldes mit einem NV-Magnetometer mit automatisierter Resonanzregelung, wobei das NV-Magnetometer ein Sensormaterial mit NV-Zentren mit jeweiligen Spinzuständen mₛ = 0, ± 1 und Resonanzfrequenzen f_{±} für Übergänge zwischen den Spinzuständen mₛ = 0 ↔ ± 1 umfasst, wobei eine Differenz f₊ - f₋ der Resonanzfrequenzen f_{±} vom äußeren Magnetfeld B abhängt, umfassend nachfolgende Schritte:
- Aufnehmen von Einzelresonanz-Signalen V_{SR-LIA} zur Bestimmung der Resonanzfrequenzen f_{±} mittels auf das Sensormaterial eingestrahlter frequenzmodulierter Mikrowellenstrahlung in Frequenzbändern basierend auf einer Mikrowellenfrequenz f_{MW} und einer Trägerfrequenz f_{SB}, wobei Mikrowellenfrequenz f_{MW} und Trägerfrequenz f_{SB} so gewählt sind, dass die Frequenzbänder die beiden Magnetresonanzen nacheinander adressieren,
- Aufnehmen eines demodulierten Doppelresonanz-Signals V_{DR-LIA} mit dispersiver Form und einem linearen Bereich um die Resonanzfrequenzen f_{±} herum, wobei Mikrowellenfrequenz f_{MW} und Trägerfrequenz f_{SB} so gewählt sind, dass f_{MW} ± f_{SB} = f_{±} ist, sodass beide Magnetresonanzen gleichzeitig angeregt werden
- Bestimmen einer Steigung des linearen Bereichs als skalaren Faktor α aus dem demodulierten Signal V_{DR-LIA};
- Beobachten einer Verstimmung Δ_{B} = V_{DR-LIA} /α der Resonanzfrequenzen f_{±} über das demodulierte Signal V_{DR-LIA} bei resonantem Einstrahlen der Mikrowellenstrahlung aufgrund äußerer Magnetfeldänderungen mittels einer Auswerteeinheit;
- Regeln der Frequenzbänder f_{MW} ± f_{SB} mit einem Regler umfassend einen Regelalgorithmus in Abhängigkeit der beobachteten Verstimmung Δ_{B}, so dass die Frequenzbänder f_{MW} ± f_{SB} auch nach erfolgter Verstimmung Δ_{B} im Bereich der bei dieser Verstimmung Δ_{B} vorliegenden Resonanzfrequenzen f_{±} der NV-Zentren bleibt; und
- Bestimmen des äußeren Magnetfeldes B aus dem Abstand 2*f_{SB} der beiden Frequenzbänder und der Verstimmung Δ_{B} mittels der Auswerteeinheit.

Der Begriff "Sensormaterial" bezieht sich auf das Material, das die NV-Zentren besitzt. Dies ist beispielsweise Diamant.

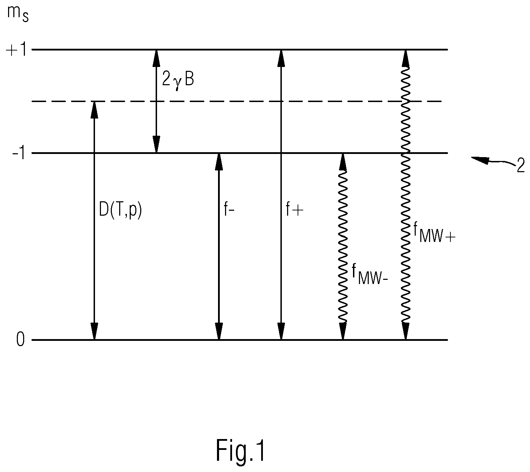

Zur näheren Erläuterung der Spinzuständen mₛ = 0, ± 1 und der Resonanzfrequenzen f_{±} für Übergänge zwischen den Spinzuständen mₛ = 0 ↔ ± 1 verweisen wir auf Fig.1.

Der Begriff "Magnetresonanz" bezeichnet das Anregen der energetisch höherliegenden Spinzustände in den NV-Zentren und somit die Absorption der Mikrowellenstrahlung bei den Resonanzfrequenzen f_{±}. Beim Übergang in den Grundzustand wird eine entsprechende Strahlung wieder emittiert. Die Magnetresonanz kann beispielsweise in Absorptionsspektren oder Emissionsspektren gemessen werden.

Die Trägerfrequenz ist dabei eine Festfrequenz, die je nach Modulationsverfahren in ihrer Amplitude, Phasenlage oder Frequenz im Rhythmus der Modulationsfrequenz geändert wird. So ändert sich beispielsweise bei der Frequenzmodulation deren Frequenz. Die Trägerfrequenz bei der Demodulation des Signals wieder zugesetzt.

Der sogenannte "skalare Faktor α" entspricht der Steigung des demodulierten Signals V_{DR-LIA} im linearen Bereich um die Resonanzfrequenz herum, wo es einen Nulldurchgang hat. Je nach Einfluss des äußeren Magnetfeldes kann der Nulldurchgang des demodulierten Signal V_{DR-LIA} in seiner Frequenz verschoben werden, da das äußere Magnetfeld die tatsächliche Resonanzfrequenz verglichen zur Resonanzfrequenz ohne Einfluss eines äußeren Magnetfelds verschiebt. Diese Verschiebung wird als Resonanzverstimmung Δ_{B} bezeichnet. Dadurch, dass der Arbeitspunkt des NV-Magnetometers mittels des Regelalgorithmus immer wieder am Punkt der steilsten Steigung des demodulierten Signals (größter Wert von α) geregelt wird, erhält man ein verbessertes Signal-zu-Rausch-Verhältnis des Messsignals.

Der Regelalgorithmus kann dabei als Softwareprogramm auf einem Regler installiert und ausgeführt werden, wobei der Regler mit der Auswerteeinheit und den Mikrowellensender zur Ausstrahlung der Mikrowellenstrahlung zur Anregung der Magnetresonanz über Daten- bzw. Steuerleitungen verbunden ist, damit gemäß Regelalgorithmus die Mikrowellenfrequenz f_{MW} in Abhängigkeit der mit der Auswerteeinheit beobachteten Verstimmung Δ_{B} geregelt werden kann. Die Auswerteeinheit kann dabei als Prozessor verbunden mit einem Speichermedium ausgeführt sein, damit das oder die entsprechenden Auswerteprogramme ausgeführt und die ausgewerteten Daten gespeichert werden können.

Beim erfindungsgemäßen NV-Magnetometer sorgt der intelligente Regelalgorithmus inklusive der dafür erforderlichen Hardwarekonfiguration dafür, dass die für den empfindlichen Sensorbetrieb notwendige Mikrowellenanregung in ihrer Frequenz im Bereich der Magnetresonanz bleibt.

Mit dem erfindungsgemäßen Verfahren lässt sich ein NV-Magnetometer mit einem erhöhten Dynamikbereich, einer höheren Bandbreite bezüglich der erfassbaren Magnetfeldänderungen und einem besseren SNR bei den Messungen betreiben. Die voranstehenden Vorteile ermöglichen auch eine gradiometrische Messung mit einem oder mehreren solchen NV-Magnetometern.

In einer Ausführungsform des Verfahrens bzw. des NV-Magnetometers umfasst das Regeln die nachfolgenden Schritte:
- Vergleichen des demodulierten Signals V_{LIA} mit einem Sollwert r = 0;
- Berechnen einer Abweichung e = r - V_{DR-LIA} = ₋ V_{DR-LIA}; und
- Verschieben der Frequenzbänder der Mikrowellenstrahlung in entgegengesetzte Richtung um Δf_{MW} mittels des Reglers.

Durch die kontinuierliche Anpassung des Arbeitspunktes des NV-Magnetometers wird der Dynamikbereich des NV-Magnetometers deutlich erhöht. Nach Magnetfeld- oder Temperaturänderungen, die ein Überschreiten des Resonanzbereichs verursachen können, ist damit keine zeitaufwändige Suche nach der Resonanz in einem breiten Frequenzspektrum mehr notwendig. Entsprechend erreicht man ebenfalls eine Erhöhung der Bandbreite des NV-Magnetometers.

In einer bevorzugten Ausführungsform des Verfahrens bzw. des NV-Magnetometers regelt der Regler dazu als integraler softwarebasierter Regler nach der Vorschrift Δf_{MW}[n] = K * (e[0] + e[1] + .... + e[n] mit K als Proportionalitätsfaktor des Reglers mit i = 0, 1, ... , n als Iterationsschritte. Hierbei ist vorzugsweise der Proportionalitätsfaktor K = 1/ α.

In einer Ausführungsform des Verfahrens bzw. des NV-Magnetometers besitzt der Regler eine Regelperiode Tc, nach der erneut die Mikrowellenfrequenz f_{MW} mit dem Regler geregelt wird, wobei die Regelperiode Tc zwischen 1µs und 10s, vorzugsweise zwischen 0,05s und 1s, noch bevorzugter 0,5s, beträgt Eine kurze Regelperiode Tc ermöglicht das Verfolgen von sich schnell ändernden Magnetfeldsignalen, kann jedoch auch die Bandbreite des NV-Magnetometers limitieren, da das Setzen der Frequenzbänder eine Totzeit mit sich bringt. Zudem verschlechtert sich durch eine lange Regelperiode Tc das Signal-zu-Rausch-Verhältnis SNR, da der optimale Arbeitspunkt (Resonanzpunkt/Nulldurchgang) nicht ausreichend gehalten werden kann. Besonders bevorzugt wird daher eine Regelperiode Tc = 0.5s.

In einer bevorzugten Ausführungsform des Verfahrens bzw. des NV-Magnetometers erzeugt ein Signalgenerator ein Signal mit der Mikrowellenfrequenz f_{MW} und ein weiterer Signalgenerator erzeugt ein frequenzmoduliertes Signal mit der Trägerfrequenz f_{SB}, einer Modulationsfrequenz fₘ und einer Modulationsamplitude f_{d} mit f_{SB}(t) = f_{SB} + f_{d} * cos(2πfₘt) mit t als der Zeit mit einer jeweiligen Leistung.

In einer bevorzugten Ausführungsform des Verfahrens bzw. des NV-Magnetometers werden die beiden Signale mittels eines Frequenzmischers frequenz-gemischt und die auf das Sensormaterial abgestrahlte Mikrowellenstrahlung umfasst die beiden Frequenzbänder f_{MW} + f_{SB}(t) und f_{MW} - f_{SB}(t), wobei f_{SB}(t) bei f_{MW} - f_{SB}(t) um π phasenverschoben ist. Vorzugsweise werden dabei Mikrowellenfrequenz f_{MW} und Trägerfrequenz f_{SB} so gewählt, dass die beiden Frequenzbänder jeweils resonant mit den Resonanzfrequenzen f_{±} sind, um beide Magnetresonanzen simultan anzuregen.

In einer bevorzugten Ausführungsform des Verfahrens bzw. des NV-Magnetometers werden beide Frequenzbänder mit individuell eingestellten Leistungen abgestrahlt. Durch die Möglichkeit, die Leistung für beide Frequenzbänder separat einzustellen, kann der Unterschied der Skalar-Faktoren der Einzelresonanz-Spektren minimiert werden und damit die Unterdrückung von Temperatur- und Druckänderungen im Doppelresonanz-Signal maximiert werden. Hierbei können je nach Ausführungsform der hardware-Konfiguration des NV-Magnetometers die Leistungen mittels eines programmierbaren Abschwächers oder mittels Anpassens der Leistung der Signalgeneratoren individuell eingestellt werden.

Die Erfindung betrifft des Weiteren ein NV-Magnetometer zur Bestimmung eines äußeren Magnetfeldes B eingerichtet zur Ausführung eines erfindungsgemässen Verfahrens zur automatisierten Resonanzregelung, umfassend
- ein Sensormaterial mit NV-Zentren mit jeweiligen Spinzuständen mₛ = 0, ± 1 und Resonanzfrequenzen f_{±} für Übergänge zwischen den Spinzuständen mₛ = 0 ↔ ± 1, wobei eine Differenz f₊ - f₋ der Resonanzfrequenzen f_{±} vom äußeren Magnetfeld B abhängt,
- einen Mikrowellensender zur Anregung von Magnetresonanzen bei den Resonanzfrequenzen f_{±} mittels auf das Sensormaterial eingestrahlter frequenzmodulierter Mikrowellenstrahlung in Frequenzbändern basierend auf einer Mikrowellenfrequenz f_{MW} und eine Trägerfrequenz f_{SB}, wobei die Mikrowellenfrequenz f_{MW} und Trägerfrequenz f_{SB} für eine Aufnahme von Einzelresonanz-Signalen V_{SR-LIA} so gewählt sind, dass die Frequenzbänder die beiden Magnetresonanzen nacheinander adressieren, und wobei Mikrowellenfrequenz f_{MW} und Trägerfrequenz f_{SB} für eine Aufnahme eines demodulierten Doppelresonanz-Signals V_{DR-LIA} so gewählt sind, dass f_{MW} ± f_{SB} = f_{±} ist, sodass beide Magnetresonanzen gleichzeitig angeregt werden;
- einen Laser zur Aussendung eines Dauerstrichbetriebs mit einer Wellenlänge im Bereich von 510 - 540 nm zur kontinuierlichen Initialisierung und Auslese der Spinzustände,
- einen geeigneten Detektor, vorzugsweise ein optischer Detektor, zur Aufnahme von frequenz-modulierten Fluoreszenzlichtes des Sensormaterials;
- einen Lock-in Verstärker zur Demodulation des Fluoreszenzlichtes, wobei bei Anregung einer oder beider Magnetresonanzen sich die Signale V_{SR-LIA} oder V_{DR-LIA} mit dispersiver Form und einem linearen Bereich um die Resonanzfrequenz herum ergeben;
- eine Auswerteeinheit zur Beobachtung der Verstimmung Δ_{B} = V_{DR-LIA} /α der Resonanzfrequenzen f_{±} über das demodulierte Signal V_{DR-LIA};
- einen Regler zur Reglung der Frequenzbänder f_{MW} ± f_{SB} mit einem Regelalgorithmus in Abhängigkeit der beobachteten Verstimmung Δ_{B}, so dass die Frequenzbänder f_{MW} ± f_{SB} auch nach erfolgter Verstimmung Δ_{B} im Bereich der bei dieser Verstimmung Δ_{B} vorliegenden Resonanzfrequenzen f_{±} der NV-Zentren bleibt;
wobei die Auswerteeinheit zur Bestimmung des äußeren Magnetfeldes B aus dem Abstand 2*f_{SB} der beiden Frequenzbänder und der Verstimmung Δ_{B} vorgesehen ist.

Beim erfindungsgemäßen NV-Magnetometer sorgt der intelligente Regelalgorithmus inklusive der dafür erforderlichen Hardwarekonfiguration dafür, dass die für den empfindlichen Sensorbetrieb notwendige Mikrowellenanregung in ihrer Frequenz im Bereich der Magnetresonanz bleibt.

Das erfindungsgemäßes NV-Magnetometer ermöglicht einen erhöhten Dynamikbereich, eine höhere Bandbreite bezüglich der erfassbaren Magnetfeldänderungen und ein besseres SNR bei den Messungen. Die voranstehenden Vorteile ermöglichen auch eine gradiometrische Messung mit einem oder mehreren solchen NV-Magnetometern.

Vorzugsweise ist hierbei das Sensormaterial aufgrund seiner besonderen Eigenschaften Diamant

In einer Ausführungsform umfasst der Mikrowellensender einen Signalgenerator zur Erzeugung eines Signals mit der Mikrowellenfrequenz f_{MW} und einen weiterer Signalgenerator zur Erzeugung eines frequenzmodulierten Signals mit der Trägerfrequenz f_{SB}, einer Modulationsfrequent fₘ und einer Modulationsamplitude f_{d} mit f_{SB}(t) = f_{SB} + f_{d} * cos(2πfₘt) mit t als der Zeit mit einer jeweiligen Leistung.

In einer weiteren Ausführungsform sind die Signalgeneratoren dazu ausgestaltet, die Leistungen der Signale anzupassen oder die Signalgeneratoren haben zur individuellen Leistungsanpassung einen Abschwächer vorgeschaltet.

Die Erfindung betrifft des Weiteren die Verwendung eines oder mehrerer erfindungsgemäßer NV-Magnetometer für gradiometrische Messungen. Gradiometrie ist die Messung einer Komponente eines Gradientenfeldes, beispielweise des Gradienten eines Magnetfeldes. Dabei wird eine Vektorkomponente mit zwei Sensoren (hier zwei NV-Magnetometer), die einen festen Abstand besitzen, gleichzeitig registriert. Gradiometrie wird in der Geomagnetik angewandt. Die Gradientenmessung benötigt präzise und schnelle Messungen, die mit dem erfindungsgemäßen NV-Magnetometer und den entsprechenden erfindungsgemäßen Verfahren ermöglicht werden.

Es sei ausdrücklich darauf hingewiesen, dass zum Zwecke der besseren Lesbarkeit "mindestens"-Ausdrücke nach Möglichkeit vermieden wurden. Vielmehr ist ein unbestimmter Artikel ("ein", "zwei" etc.) im Normalfall als "mindestens ein, mindestens zwei, etc." zu verstehen, sofern sich nicht aus dem Kontext ergibt, dass dort "genau" die angegebene Anzahl gemeint ist.

An dieser Stelle sei ebenfalls noch erwähnt, dass im Rahmen der hier vorliegenden Patentanmeldung der Ausdruck "insbesondere" immer so zu verstehen ist, dass mit diesem Ausdruck ein optionales, bevorzugtes Merkmal eingeleitet wird. Der Ausdruck ist demzufolge nicht als "und zwar" und nicht als "nämlich" zu verstehen.

Es versteht sich, dass Merkmale der vorstehend bzw. in den Ansprüchen beschriebenen Lösungen gegebenenfalls auch abweichend von den Anspruchsrückbezügen kombiniert werden können, um die vorliegend erzielbaren Vorteile und Effekte entsprechend einzeln oder kumuliert umsetzen zu können.

### Kurze Beschreibung der Figuren

Zusätzlich sind weitere Merkmale, Effekte und Vorteile vorliegender Erfindung anhand anliegender Zeichnung und nachfolgender Beschreibung erläutert. Komponenten, welche in den einzelnen Figuren wenigstens im Wesentlichen hinsichtlich ihrer Funktion übereinstimmen, sind hierbei mit gleichen Bezugszeichen gekennzeichnet, wobei die Komponenten nicht in allen Figuren beziffert und erläutert sein müssen.

Die Zeichnung zeigen:
- Fig. 1:: Schematische Darstellung von Spinzuständen eines NV-Zentrums im Sensormaterial mit den Abhängigkeiten der Energieniveaus von Magnetfeld, Temperatur und Druck sowie deren Resonanz- und Mikrowellenanregungen;
- Fig.2:: Schematische Darstellung von (a) einem Signalflussdiagramm, und von (b) Frequenzanteile (Frequenzbänder) der auf das Sensormaterial abgestrahlte Mikrowellenstrahlung in einer ersten Ausführung eines Magnetfeld-Messschemas;
- Fig.3:: Schematische Darstellung von (a) einem Signalflussdiagramm, und von (b) Frequenzanteile (Frequenzbänder) der auf das Sensormaterial abgestrahlte Mikrowellenstrahlung in einer zweiten alternativen Ausführung eines Magnetfeld-Messschemas;
- Fig.4:: Schematische Darstellung (a) der Einzelresonanzsignale in Abhängigkeit einer Resonanzverstimmung aufgrund von Magnetfeldänderungen (oben: vor der Änderung; unten nach der Änderung), (b) der Einzelresonanzsignale in Abhängigkeit einer Resonanzverstimmung aufgrund von Druck- und Temperaturänderungen (oben: vor der Änderung; unten nach der Änderung), und (c) ein aus der Addition beider Einzelsignale resultierendes demoduliertes Signal;
- Fig.5:: Schematische Darstellung (a) eines Signalflussdiagramms für den Regelalgorithmus des Reglers, und (b) die Resonanzstimmung des demodulierten Signals durch Magnetfeldänderung (links) und Rückverschiebung durch den Regelalgorithmus;
- Fig.6:: eine Ausführungsform des erfindungsgemäßen NV-Magnetometers; und
- Fig.7:: eine Ausführungsform des erfindungsgemäßen Verfahrens.

### Ausführungsbeispiele

Fig.1 zeigt eine schematische Darstellung von Spinzuständen eines NV-Zentrums im Sensormaterial 2 des NV-Magnetometers 1 mit den Abhängigkeiten der Energieniveaus von Magnetfeld B, Temperatur T und Druck p sowie deren Resonanz- und Mikrowellenanregungen mit einer Mikrowellenfrequenz f_{MW.}, wobei f_{MW+} die Mikrowellenfrequenz zur Anregung der Resonanzfrequenz f₊ und f_{MW-} die Mikrowellenfrequenz zur Anregung der Resonanzfrequenz f₋ bezeichnet. Die Spin-Grundzustand ist mit mₛ = 0 sowie die beiden angeregten Spinzustände mit mₛ = 1 bzw. mit mₛ = -1 bezeichnet, je nach Ausrichtung des Spins zum äußeren Magnetfeld. Die Resonanzfrequenzen *f*_{±} der Magnetresonanzen *mₛ* = 0 ↔ ±1 sind abhängig von Magnetfeld B, Temperatur T und Druck p: ${f}_{\pm } = D \left(T, p\right) \pm γB$

Temperatur- und Druckschwankungen können von Magnetfeldänderungen separiert werden, wenn beide Resonanzfrequenzen f_{±} bekannt sind, indem die beiden Resonanzfrequenzen voneinander subtrahiert werden und die Differenz nur noch proportional zum äußeren Magnetfeld B ist: ${f}_{+} - {f}_{-} = 2 γB$

γ ist hierbei das gyromagnetische Verhältnis des NV-Zentrums im Sensormaterial 2.

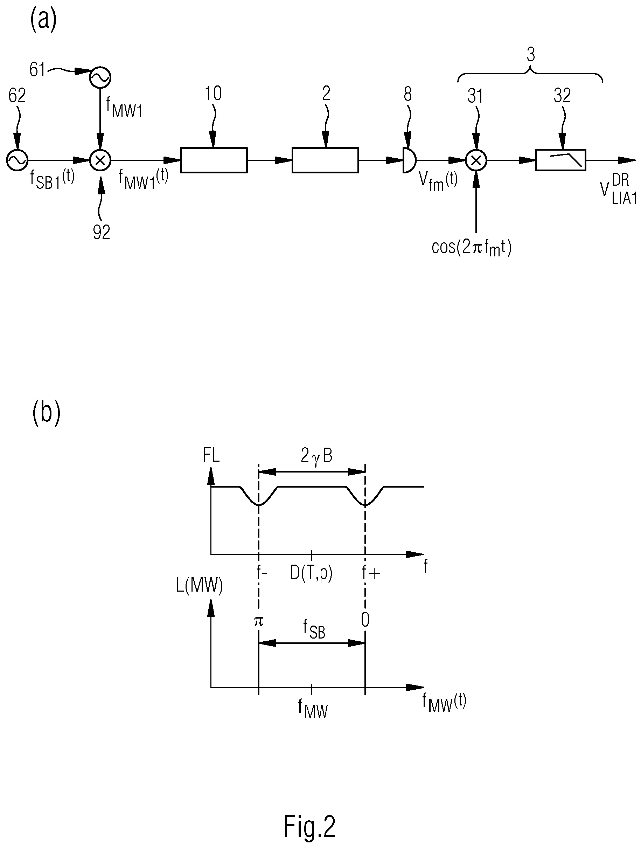

Fig.2 zeigt eine schematische Darstellung von (a) optisch-detektierter Magnetresonanz unter Einstrahlung einer frequenzmodulierten Mikrowellenstrahlung auf ein NV-Zentrum, und (b) eines mittels eines Lock-in Verstärkers 3 demodulierten Signal V_{DR-LIA}. Das Magnetfeld-Messschema basiert auf den folgenden Techniken:
- Lock-in Detektion: (Frequenz-)Modulation der eingestrahlten Mikrowelle (Mikrowellenfrequenz f_{MW} und eine Trägerfrequenz f_{SB}) und anschließende Demodulation der optisch-detektierten Magnetresonanz mittels eines Lock-in Verstärkers 3. Das demodulierte Signal V_{DR-LIA} der Magnetresonanz hat eine dispersive Form und ist um die Resonanzfrequenz linear, siehe Fig.2a.
- Skalarer Faktor α: Hierfür muss zunächst die Steigung ("skalarer Faktor") des linearen Bereichs des demodulierten Signales V_{DR-LIA} bestimmt werden. Die Mikrowelle wird dann resonant eingestrahlt. Ändert sich die Resonanzfrequenz aufgrund von Magnetfeld-, Temperatur- oder Druckänderungen, so kann die Verstimmung von der Resonanzfrequenz über das Signal des Lock-in Verstärkers 3 ausgewertet werden. Bei Auswertung des Differenzsignals der beiden Magnetresonanzen werden die Einflüsse von Temperatur T und Druck p und somit eventuelle (Resonanz)Verstimmung aufgrund von Druck- oder Temperaturänderungen ΔT eliminiert, sodass lediglich der Einfluss des äußeren Magnetfeldes als (magnetische) Verstimmung den nachfolgenden Beitrag hat: Δ_{B} = V_{DR-LIA} /α.

Fig.2 zeigt eine schematische Darstellung von (a) einem Signalflussdiagramm für ein erfindungsgemäßes NV-Magnetometer 1, und von (b) Frequenzanteile (Frequenzbänder) der auf das Sensormaterial 2 abgestrahlte Mikrowellenstrahlung in einer ersten Ausführung eines Magnetfeld-Messschemas. In Fig.2a erzeugt ein Signalgenerator 61 ein Signal mit Frequenz *f_{MW}* und ein weiterer Signalgenerator 62 ein frequenz-moduliertes Signal mit der Trägerfrequenz *f_{SB}*, der Modulationsfrequenz *fₘ* und einer Modulationsamplitude *f_{d}*: ${f}_{SB} \left(t\right) = {f}_{SB} + {f}_{d} cos \left(2{πf}_{m}t\right)$

Die Signale werden anschließend in einem Leistungsaddierer 92 frequenz-gemischt, so dass das auf das Sensormaterial 2, beispielsweise ein Diamant, mittels einer Antenne 10 abgestrahlte Signal folgende Frequenzanteile enthält: ${f}_{MW} + {f}_{SB} + {f}_{d} cos \left(2{πf}_{m}t\right) und {f}_{MW} - {f}_{SB} + {f}_{d} cos \left(2{πf}_{m}t+π\right)$

Wie sich zeigt, ergibt sich durch die Frequenzmischung ein Phasenunterschied von π bzw. 180° zwischen den beiden Frequenzanteilen. Die Systemparameter *f_{MW}* und *f_{SB}* werden so gewählt, dass die Frequenzanteile jeweils resonant mit den Übergängen *mₛ* = 0 ↔ ±1 sind (siehe Fig.2b). Die resultierende Magnetresonanz (Fluoreszenz FL) wird über einen optischen Photodetektor 8 gemessen und mittels eines jeweiligen Lock-in Verstärkers 3 mit Frequenzmischer 31 und Tiefpassfilter 32 in ein Doppelresonanz-Signal V_{DR-LIA} umgewandelt.

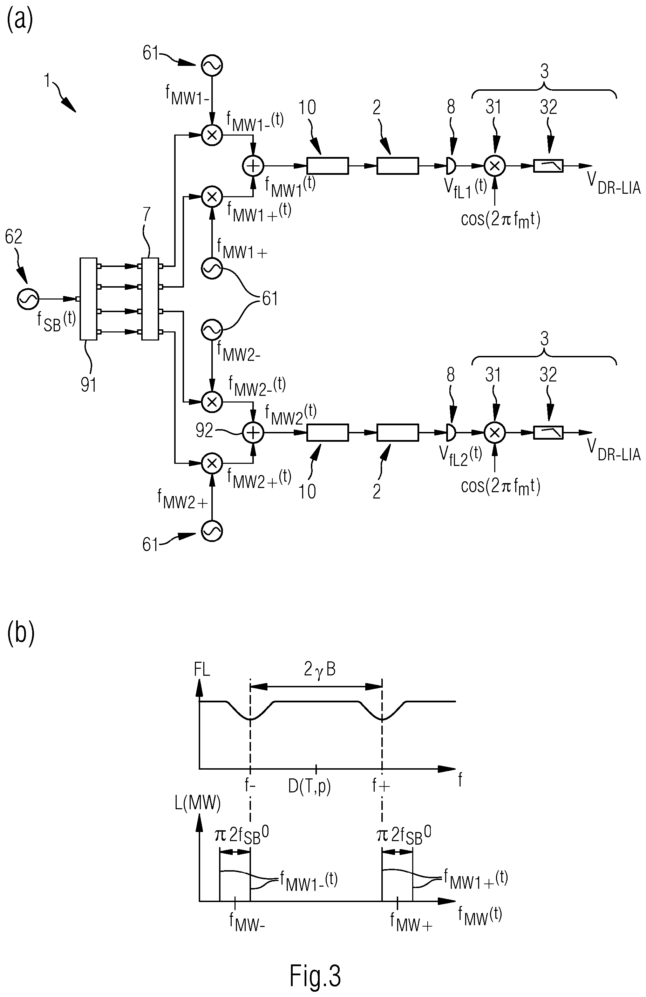

Fig.3 zeigt eine schematische Darstellung von (a) einem Signalflussdiagramm für ein erfindungsgemäßes NV-Magnetometer 1, und von (b) Frequenzanteile (Frequenzbänder) der auf das Sensormaterial 2, hier ein Diamant, abgestrahlte Mikrowellenstrahlung in einer zweiten alternativen Ausführung eines Magnetfeld-Messschema mit alternativer Hardware-Konfiguration des NV-Magnetometers 1 im Vergleich zu der in Fig.2 gezeigten Konfiguration. Die in Fig.3a gezeigte Methode beruht auf dem gleichen Funktionsprinzip wie bei Fig.2a, allerdings kann hier die Leistung der Frequenzbänder, welche die Magnetresonanzen adressieren, individuell eingestellt werden. Dies erfolgt entweder durch
- den programmierbaren Abschwächer 7 oder
- durch eine Anpassung der Leistung der Signalgeneratoren 61, 62, welche die Mikrowellen-Frequenzen erzeugen.

Die jeweiligen Frequenzbänder werden über jeweilige Antennen 10 auf das Sensormaterial 2 abgestrahlt und die resultierende Magnetresonanz (Fluoreszenz FL) über einen jeweiligen optischen Photodetektor 8 gemessen und mittels eines jeweiligen Lock-in Verstärkers 3 mit Frequenzmischer 31 und Tiefpassfilter 32 in ein Doppelresonanz-Signal V_{DR-LIA} umgewandelt. Zur Erzeugung der beiden separaten Frequenzbänder umfasst die Schaltung gemäß Fig.2a einen entsprechenden Leistungsteiler 91 vor dem programmierbaren Abschwächer und jeweilige Leistungsaddierer 92 zur Erzeugung der durch die jeweiligen Antennen 10 abgestrahlten Mikrowellenstrahlung der jeweiligen Frequenzbänder. Durch die Möglichkeit, die Leistung für beide Frequenzbänder separat einzustellen, kann der Unterschied der Skalar-Faktoren α der Einzelresonanz-Spektren V_{SR-LIA} minimiert werden und damit die Unterdrückung von Temperatur- und Druckänderungen im Doppelresonanz-Signal V_{DR-LIA} maximiert werden. Die Modulationsphase in Fig.3b ist über dem jeweiligen Frequenzanteil als 0 oder π angegeben.

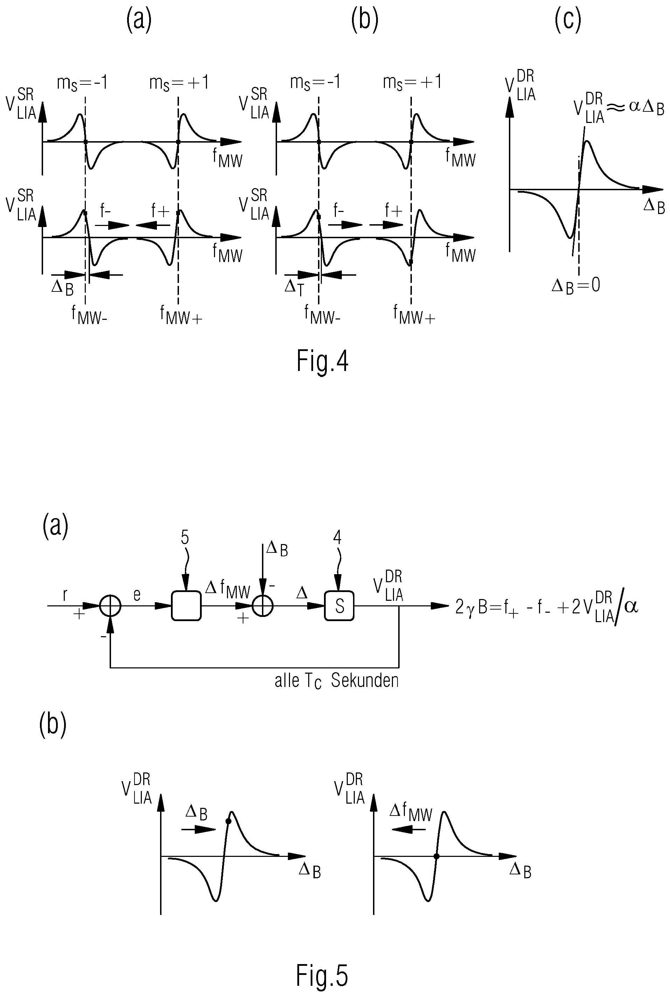

Fig.4 zeigt eine schematische Darstellung (a) der Einzelresonanzsignale V_{SR-LIA} als Funktion der Mikrowellenfrequenz f_{MW} in Abhängigkeit einer Resonanzverstimmung Δ_{B} aufgrund von Magnetfeldänderungen (oben: vor der Änderung; unten nach der Änderung), (b) der Einzelresonanzsignale V_{SR-LIA} als Funktion der Mikrowellenfrequenz f_{MW} in Abhängigkeit einer Resonanzverstimmung Δ_{T} aufgrund von Druck- und Temperaturänderungen (oben: vor der Änderung; unten nach der Änderung), und (c) ein aus der Addition beider Einzelsignale V_{SR-LIA} resultierendes demoduliertes Signal V_{DR-LIA} (Doppelresonanz-Signal). Um den Einfluss von Magnetfeld-, Temperatur- und Druckänderungen auf das demodulierte Signal V_{DR-LIA} zu verstehen, ist es sinnvoll, die einzelnen Anteile der Magnetresonanzen (Einzelresonanz-Signale V_{SR-LIA}) zu betrachten. Folgende Schlüsse können hieraus gezogen werden:
- Aus der relativen Modulationsphase von π bzw. 180° zwischen den beiden Frequenzanteilen resultiert eine vertikale Spiegelung der Einzelresonanz-Signale V_{SR-LIA}.
- Die Einzelresonanz-Signale V_{SR-LIA} addieren sich konstruktiv bei Magnetfeldänderungen während Temperatur- und Druckänderungen zu unterschiedlichen Vorzeichen der Einzelresonanz-Signale V_{SR-LIA} führen und diese sich damit destruktiv addieren.
- Das Doppelresonanz-Signal V_{DR-LIA} ist daher nur von Magnetfeldänderungen abhängig. Verstimmungen Δ*_{B}* von der Resonanzfrequenz hervorgerufen durch eine Magnetfeldänderung lassen sich damit ausdrücken als: Δ*_{B} = V_{DR-LIA}*/*α*.

Daraus lässt sich folgendes Messprotokoll ableiten:
1. Einzelresonanz-Spektrum V_{SR-LIA} der beiden Magnetresonanzen aufnehmen → Bestimmung von *f*₊ und *f₋* (Resonanzfrequenzen zum Zeitpunkt der Kalibrierung)
2. Doppelresonanz-Spektrum V_{DR-LIA} aufnehmen → Bestimmung von skalarem Faktor *α*
3. Systemparameter *f_{MW}* und *f_{SB}* werden fix eingestellt, so dass die Frequenzanteile bei *f*₊ und *f₋* liegen → Kontinuierliche Bestimmung des Magnetfeldes über folgende Gleichung: $2 γB = {f}_{+} - {f}_{-} + 2 {V}_{DR - LIA} / α$

Fig.5 zeigt eine schematische Darstellung (a) eines Signalflussdiagramms für den Regelalgorithmus des Reglers, und (b) die Resonanzverstimmung Δ_{B} des demodulierten Signals durch Magnetfeldänderung (links) und Rückverschiebung durch den Regelalgorithmus. Der Regelalgorithmus beruht auf einer Rückkoppelschleife, welche in Fig.5a dargestellt ist. Hierbei wird von Schritt 3 des oben aufgeführten Messprotokolls ausgegangen:
- Eine Magnetfeldänderung führt zu einer Resonanzverstimmung Δ_{B}
- Die Resonanzverstimmung Δ_{B} führt zu einer Änderung des Ausgangsignals des Regelsystems *S*, siehe Fig.5b, linke Seite.
- Der Output wird dann mit dem Sollwert *r* = 0 verglichen und die Abweichung e *=* r *- V_{DR-LIA}* = -*V_{DR-LIA}* berechnet. Der Regler 5 operiert hierbei in diskreten Zeitabständen, d.h. alle *T_{C}* Sekunden.

Der Regler 5 verschiebt dann die Frequenzbänder in entgegengesetzte Richtung um Δ*f_{MW}* (durch Anpassung der Systemparameter *f_{MW}* und *f_{SB}*), siehe Fig.5b, rechte Seite. Hierbei wird ein integraler, softwarebasierter Regler 5 verwendet, welcher nach folgender Vorschrift regelt: $Δ {f}_{MW} \left[n\right] = K \left(e\left[0\right]+e\left[1\right]+⋯+e\left[n\right]\right)$

Hierbei ist *K* der Proportionalitätsfaktor des Reglers und *i* = 0,1, ... , *n* der Iterationsschritt. Hierbei sollte der Proportionalitätsfaktor K wie folgt gewählt werden, um die Abweichung zu eliminieren (*e* = 0): *K =* 1/*α*. Für die Regelperiode *T_{C}* gilt vorzugsweise: eine kurze Regelperiode ermöglicht das Verfolgen von sich schnell ändernden Magnetfeldsignalen, kann jedoch auch die Bandbreite des NV-Magnetometers 1 limitieren, da das Setzen der Frequenzbänder eine Totzeit mit sich bringt. Zudem verschlechtert sich durch eine lange Regelperiode das Signal-Rausch-Verhältnis, da der optimale Arbeitspunkt (Resonanzpunkt/Nulldurchgang) nicht ausreichend gehalten werden kann. Beispielsweise kann eine Regelzeit von *T_{C}* = 0.5s verwendet werden. Für das Ausgangssignal des Regelsystems *2yB = f*₊ *- f₋ +* 2*V_{DR-LIA}*/*α* bezeichnet *f*_{±} die Lage der Frequenzbänder nach der letzten Operation des Reglers 5.

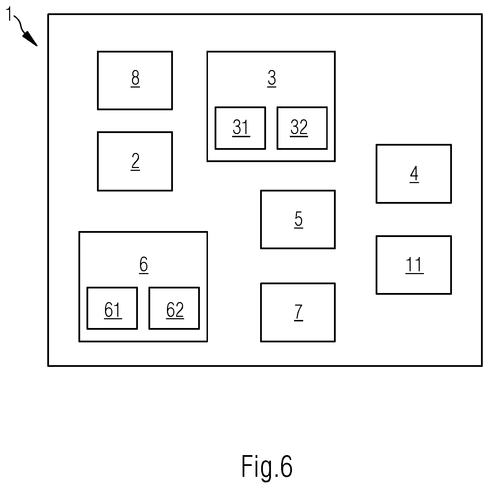

Fig.6 zeigt eine Ausführungsform des erfindungsgemäßen NV-Magnetometers 1, das ein Sensormaterial 2, einen Lock-in Verstärker 3 mit Frequenzmischer 31 und Tiefpassfilter 32, eine Auswerteeinheit 4, einen Regler 5 mit auf dem Regler ausgeführten Regelalgorithmus, einen Mikrowellensender 6 mit einem Signalgenerator 61 für ein Signal mit der Mikrowellenfrequenz f_{MW} und mit einem Signalgenerator 62 für ein frequenzmoduliertes Signal mit der Trägerfrequenz f_{SB}, einer Modulationsfrequent fm und einer Modulationsamplitude f_{d}, einem programmierbaren Abschwächer und einem optischen Detektor zur Aufnahme der Einzelresonanz-Signale V_{SR-LIA} (z.B. ein Photodetektor) umfasst. Des Weiteren kann das NV-Magnetometer die hier nicht gezeigten Leistungsteiler 91, Leistungsaddierer 62 und Antennen 10 zur Ausstrahlung der Mikrowellenstrahlung auf das Sensormaterial 2 umfassen (siehe dazu Fig. 2a und 3a). Außerdem umfasst das NV-Magnetometer 1 einen Laser 11 zur Aussendung eines Dauerstrichbetriebs mit einer Wellenlänge im Bereich von 510 - 540 nm zur kontinuierlichen Initialisierung und Auslese der Spinzustände.

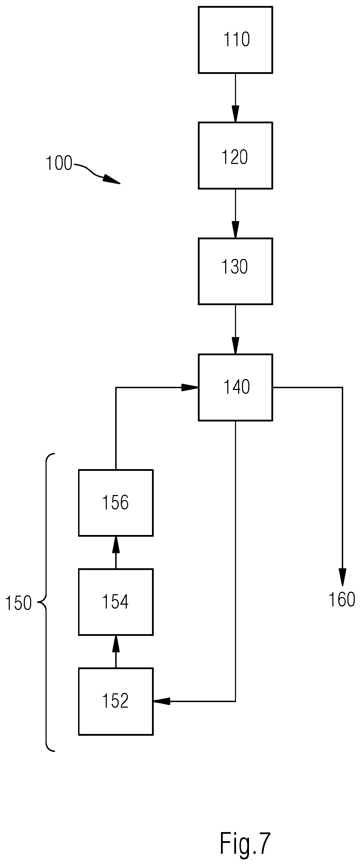

Fig.7 zeigt eine Ausführungsform des erfindungsgemäßen Verfahrens 100 zur Bestimmung eines äußeren Magnetfeldes mit einem NV-Magnetometer 1 mit automatisierter Resonanzregelung, wobei das NV-Magnetometer 1 ein Sensormaterial 2 mit NV-Zentren mit jeweiligen Spinzuständen mₛ = 0, ± 1 und Resonanzfrequenzen f_{±} für Übergänge zwischen den Spinzuständen mₛ = 0 ↔ ± 1 umfasst, wobei eine Differenz f₊ - f₋ der Resonanzfrequenzen f_{±} vom äußeren Magnetfeld B abhängt, umfassend nachfolgende Schritte des Aufnehmens 110 von Einzelresonanz-Signalen V_{SR-LIA} zur Bestimmung der Resonanzfrequenzen f_{±} mittels auf das Sensormaterial 2 eingestrahlter frequenzmodulierter Mikrowellenstrahlung in Frequenzbändern basierend auf einer Mikrowellenfrequenz f_{MW} und einer Trägerfrequenz f_{SB}, wobei Mikrowellenfrequenz f_{MW} und Trägerfrequenz f_{SB} so gewählt sind, dass die Frequenzbänder die beiden Magnetresonanzen nacheinander adressieren; des Aufnehmens 120 eines Doppelresonanz-Signals V_{DR-LIA} mit dispersiver Form und einem linearen Bereich um die Resonanzfrequenz f_{±} herum, wobei Mikrowellenfrequenz f_{MW} und Trägerfrequenz f_{SB} so gewählt sind, dass f_{MW} ± f_{SB} = f_{±} ist, sodass beide Magnetresonanzen gleichzeitig angeregt werden; des Bestimmens 130 einer Steigung des linearen Bereichs als skalaren Faktor α aus dem demodulierten Signal V_{DR-LIA}; des Beobachtens 140 einer Verstimmung Δ_{B} = V_{DR-LIA} /α der Resonanzfrequenzen f_{±} über das demodulierte Signal V_{DR-LIA} bei resonantem Einstrahlen der Mikrowellenstrahlung aufgrund äußerer Magnetfeldänderungen mittels einer Auswerteeinheit 4; des Regelns 150 der Frequenzbänder f_{MW} ± f_{SB} mit einem Regler 5 umfassend einen Regelalgorithmus in Abhängigkeit der beobachteten Verstimmung Δ_{B}, so dass die Frequenzbänder f_{MW} ± f_{SB} auch nach erfolgter Verstimmung Δ_{B} im Bereich der bei dieser Verstimmung Δ_{B} vorliegenden Resonanzfrequenzen f_{±} der NV-Zentren bleibt; und des Bestimmens 160 des äußeren Magnetfeldes B aus dem Abstand 2*f_{SB} der beiden Frequenzbänder und der Verstimmung Δ_{B} mittels der Auswerteeinheit 4, wobei hier das Regeln 150 die nachfolgenden Schritte des Vergleichens 152 des demodulierten Signals V_{DR-LIA} mit einem Sollwert r = 0; des Berechnens 154 einer Abweichung e = r - V_{DR-LIA} = ₋ V_{DR-LIA}; und des Verschiebens 156 der Frequenzbänder der Mikrowellenstrahlung in entgegengesetzte Richtung um Δf_{MW} mittels des Reglers 5 umfasst. Außerdem können die weiteren Schritte und Maßnahmen der Ansprüche 3 - 10 im erfindungsgemäßen Verfahren 100 umgesetzt werden (nicht in Fig.7 gezeigt)

An dieser Stelle sei explizit darauf hingewiesen, dass Merkmale der vorstehend bzw. in den Ansprüchen und/oder Figuren beschriebenen Lösungen gegebenenfalls auch kombiniert werden können, um auch erläuterte Merkmale, Effekte und Vorteile entsprechend kumuliert umsetzen bzw. erzielen zu können.

Es versteht sich, dass es sich bei dem vorstehend erläuterten Ausführungsbeispiel lediglich um eine erste Ausgestaltung der vorliegenden Erfindung handelt. Insofern beschränkt sich die Ausgestaltung der Erfindung nicht auf dieses Ausführungsbeispiel.

### Liste der verwendeten Bezugszeichen

- 1: NV-Magnetometer
- 2: Sensormaterial (Diamant)
- 3: Lock-in Verstärker
- 31: Frequenzmischer Tiefpassfilter
- 32 4: Auswerteeinheit
- 5: Regler
- 6: Mikrowellensender
- 61: Signalgenerator für ein Signal mit der Mikrowellenfrequenz f_{MW}
- 62: Signalgenerator für ein frequenzmoduliertes Signal mit der Trägerfrequenz f_{SB}, einer Modulationsfrequent fₘ und einer Modulationsamplitude f_{d}
- 7: programmierbaren Abschwächer
- 8: Detektor zur Aufnahme der Einzelresonanz-Signale V_{SR-LIA} (z.B. Photodetektor)
- 91: Leistungsteiler
- 92: Leistungsaddierer
- 10: Antenne (Antenne 1, Antenne 2)
- 11: Laser

- 100: Verfahren zur Bestimmung eines äußeren Magnetfeldes mit einem NV-Magnetometer mit automatisierter Resonanzregelung
- 110: Aufnehmen von Einzelresonanz-Signalen V_{SR-LIA} zur Bestimmung der Resonanzfrequenzen f_{±} mittels auf das Sensormaterial eingestrahlter frequenzmodulierter Mikrowellenstrahlung in Frequenzbändern
- 120: Aufnehmen eines Doppelresonanz-Signals V_{DR-LIA} mit dispersiver Form und einem linearen Bereich um die Resonanzfrequenz f_{±} herum
- 130: Bestimmen einer Steigung des linearen Bereichs als skalaren Faktor α aus dem demodulierten Signal V_{DR-LIA}
- 140: Beobachtung einer Verstimmung Δ_{B} = V_{DR-LIA} /α der Resonanzfrequenzen f_{±} über das demodulierte Signal V_{DR-LIA} bei resonantem Einstrahlen der Mikrowellenstrahlung
- 150: Regeln der Mikrowellenfrequenz f_{MW} mit einem Regler umfassend einen Regelalgorithmus in Abhängigkeit der beobachteten Verstimmung Δ_{B}
- 152: Vergleichen des demodulierten Signals V_{LIA} mit einem Sollwert r = 0
- 154: Berechnen einer Abweichung e = r - V_{LIA} = ₋ V_{LIA}
- 156: Verschieben der Frequenzbänder der Mikrowellenstrahlung in entgegengesetzte Richtung um Δf_{MW} mittels des Reglers
- 160: Bestimmung des äußeren Magnetfeldes B

- α: skalaren Faktor
- γ: gyromagnetisches Verhältnis des NV-Zentrums
- B: äußeres Magnetfeld
- D(T,P): Energieniveau abhängig von Druck und Temperatur
- Δ_{B}: (Resonanz)Verstimmung aufgrund von Magnetfeldänderungen (magnetische Verstimmung)
- Δ_{T}: (Resonanz)Verstimmung aufgrund von Druck- oder Temperaturänderungen
- e: Abweichung e = r - V_{LIA} = ₋ V_{LIA}
- f_{±}: Resonanzfrequenzen für Übergänge zwischen Spinzuständen mₛ = 0 ↔ ± 1
- f_{MW}: Mikrowellenfrequenz
- f_{MW+}: Mikrowellenfrequenz zur Anregung der Resonanzfrequenz f₊
- f_{MW-}: Mikrowellenfrequenz zur Anregung der Resonanzfrequenz f₋
- f_{SB}: Trägerfrequenz
- Δf_{MW}: Verschiebung der Frequenzbänder der Mikrowellenstrahlung in entgegengesetzte Richtung durch den Regler
- FL: Fluoreszenz
- L: Leistung
- mₛ: Spinzustände (0 = Grundzustand; ±1: angeregte Zustände)
- p: Druck
- r: Sollwert des Reglers
- S: Ausgangsignals des Regelsystems
- T: Temperatur
- Tc: Regelperiode
- V_{SR-LIA}: Einzelresonanz-Signale
- V_{DR-LIA}: demodulierten Signals

## Patentansprüche

1. Ein Verfahren (100) zur Bestimmung eines äußeren Magnetfeldes mit einem NV-Magnetometer (1) mit automatisierter Resonanzregelung, wobei das NV-Magnetometer (1) ein Sensormaterial (2) mit NV-Zentren mit jeweiligen Spinzuständen mₛ = 0, ± 1 und Resonanzfrequenzen f_{±} für Übergänge zwischen den Spinzuständen mₛ = 0 ↔ ± 1 umfasst, wobei eine Differenz f₊ - f₋ der Resonanzfrequenzen f_{±} vom äußeren Magnetfeld B abhängt, umfassend nachfolgende Schritte:
- Aufnehmen (110) von Einzelresonanz-Signalen V_{SR-LIA} zur Bestimmung der Resonanzfrequenzen f_{±} mittels auf das Sensormaterial (2) eingestrahlter frequenzmodulierter Mikrowellenstrahlung in Frequenzbändern basierend auf einer Mikrowellenfrequenz f_{MW} und einer Trägerfrequenz f_{SB}, wobei Mikrowellenfrequenz f_{MW} und Trägerfrequenz f_{SB} so gewählt sind, dass die Frequenzbänder die beiden Magnetresonanzen nacheinander adressieren;
- Aufnehmen (120) eines demodulierten Doppelresonanz-Signals V_{DR-LIA} mit dispersiver Form und einem linearen Bereich um die Resonanzfrequenzen f_{±} herum, wobei Mikrowellenfrequenz f_{MW} und Trägerfrequenz f_{SB} so gewählt sind, dass f_{MW} ± f_{SB} = f_{±} ist, sodass beide Magnetresonanzen gleichzeitig angeregt werden;
- Bestimmen (130) einer Steigung des linearen Bereichs als skalaren Faktor α aus dem demodulierten Signal V_{DR-LIA};
- Beobachten (140) einer Verstimmung Δ_{B} = V_{DR-LIA} /α der Resonanzfrequenzen f_{±} über das demodulierte Signal V_{DR-LIA} bei resonantem Einstrahlen der Mikrowellenstrahlung aufgrund äußerer Magnetfeldänderungen mittels einer Auswerteeinheit (4);
- Regeln (150) der Frequenzbänder f_{MW} ± f_{SB} mit einem Regler (5) umfassend einen Regelalgorithmus in Abhängigkeit der beobachteten Verstimmung Δ_{B}, so dass die Frequenzbänder f_{MW} ± f_{SB} auch nach erfolgter Verstimmung Δ_{B} im Bereich der bei dieser Verstimmung Δ_{B} vorliegenden Resonanzfrequenzen f_{±} der NV-Zentren bleibt; und
- Bestimmen (160) des äußeren Magnetfeldes B aus dem Abstand 2*f_{SB} der beiden Frequenzbänder und der Verstimmung Δ_{B} mittels der Auswerteeinheit (4).

2. Das Verfahren (100) nach Anspruch 1, wobei das Regeln (150) die nachfolgenden Schritte umfasst:
- Vergleichen (152) des demodulierten Signals V_{DR-VIA} mit einem Sollwert r = 0;
- Berechnen (154) einer Abweichung e = r - V_{DR-LIA} = ₋ V_{DR-LIA}; und
- Verschieben (156) der Frequenzbänder der Mikrowellenstrahlung in entgegengesetzte Richtung um Δf_{MW} mittels des Reglers (5).

3. Das Verfahren (100) nach Anspruch 2, wobei der Regler (5) als integraler softwarebasierter Regler (5) nach der Vorschrift Δf_{MW}[n] = K * (e[0] + e[1] + .... + e[n] mit K als Proportionalitätsfaktor des Reglers (5) mit i = 0, 1, ... , n als Iterationsschritte regelt.

4. Das Verfahren (100) nach Anspruch 3, wobei der Proportionalitätsfaktor K = 1/ α ist.

5. Das Verfahren (100) nach einem der voranstehenden Ansprüchen, wobei der Regler (5) eine Regelperiode Tc besitzt, nach der erneut die Mikrowellenfrequenz f_{MW} mit dem Regler geregelt wird, wobei die Regelperiode Tc zwischen 1µs und 10s, vorzugsweise zwischen 0,05s und 1s, noch bevorzugter 0,5s, beträgt.

6. Das Verfahren (100) nach einem der voranstehenden Ansprüche, wobei ein Signalgenerator (61) ein Signal mit der Mikrowellenfrequenz f_{MW} und ein weiterer Signalgenerator (62) ein frequenzmoduliertes Signal mit der Trägerfrequenz f_{SB}, einer Modulationsfrequenz fₘ und einer Modulationsamplitude f_{d} mit f_{SB}(t) = f_{SB} + f_{d} * cos(2πfₘt) mit t als der Zeit mit einer jeweiligen Leistung erzeugt.

7. Das Verfahren (100) nach Anspruch 6, wobei die beiden Signale mittels eines Frequenzmischers (9) frequenz-gemischt werden und die auf das Sensormaterial (2) abgestrahlte Mikrowellenstrahlung die beiden Frequenzbänder f_{MW} + f_{SB}(t) und f_{MW} - f_{SB}(t) umfasst, wobei f_{SB}(t) bei f_{MW} - f_{SB}(t) um π phasenverschoben ist.

8. Das Verfahren (100) nach Anspruch 7, wobei Mikrowellenfrequenz f_{MW} und Trägerfrequenz f_{SB} so gewählt sind, dass die beiden Frequenzbänder jeweils resonant mit den Resonanzfrequenzen f_{±} sind.

9. Das Verfahren (100) nach einem der Ansprüche 6 bis 8, wobei beide Frequenzbänder mit individuell eingestellten Leistungen abgestrahlt werden.

10. Das Verfahren (100) nach Anspruch 9, wobei die Leistungen mittels eines programmierbaren Abschwächers (7) oder mittels Anpassens der Leistung der Signalgeneratoren (61, 62) individuell eingestellt werden.

11. Ein NV-Magnetometer (1) zur Bestimmung eines äußeren Magnetfeldes B eingerichtet zur Ausführung eines Verfahrens (100) zur automatisierten Resonanzregelung nach einem der voranstehenden Ansprüche, umfassend
- ein Sensormaterial (2) mit NV-Zentren mit jeweiligen Spinzuständen mₛ = 0, ± 1 und Resonanzfrequenzen f_{±} für Übergänge zwischen den Spinzuständen mₛ = 0 ↔ ± 1, wobei eine Differenz f₊ - f₋ der Resonanzfrequenzen f_{±} vom äußeren Magnetfeld B abhängt,
- einen Mikrowellensender (6) zur Anregung von Magnetresonanzen bei den Resonanzfrequenzen f_{±} mittels auf das Sensormaterial (2) eingestrahlter frequenzmodulierter Mikrowellenstrahlung in Frequenzbändern basierend auf einer Mikrowellenfrequenz f_{MW} und eine Trägerfrequenz f_{SB}, wobei die Mikrowellenfrequenz f_{MW} und Trägerfrequenz f_{SB} für eine Aufnahme von Einzelresonanz-Signalen V_{SR-LIA} so gewählt sind, dass die Frequenzbänder die beiden Magnetresonanzen nacheinander adressieren, und wobei Mikrowellenfrequenz f_{MW} und Trägerfrequenz f_{SB} für eine Aufnahme eines demodulierten Doppelresonanz-Signals V_{DR-LIA} so gewählt sind, dass f_{MW} ± f_{SB} = f_{±} ist, sodass beide Magnetresonanzen gleichzeitig angeregt werden;
- einen Laser (11) zur Aussendung eines Dauerstrichbetriebs mit einer Wellenlänge im Bereich von 510 - 540 nm zur kontinuierlichen Initialisierung und Auslese der Spinzustände,
- einen geeigneten Detektor (8), vorzugsweise ein optischer Detektor, zur Aufnahme von frequenz-modulierten Fluoreszenzlichtes des Sensormaterials (2);
- einen Lock-in Verstärker (3) zur Demodulation des Fluoreszenzlichtes, wobei bei Anregung einer oder beider Magnetresonanzen sich die Signale V_{SR-LIA} oder V_{DR-LIA} mit dispersiver Form und einem linearen Bereich um die Resonanzfrequenzen f_{±} herum ergeben;
- eine Auswerteeinheit (4) zur Beobachtung der Verstimmung Δ_{B} = V_{DR-LIA} /α der Resonanzfrequenzen f_{±} über das demodulierte Signal V_{DR-LIA};
- einen Regler (5) zur Reglung der Frequenzbänder f_{MW} ± f_{SB} mit einem Regelalgorithmus in Abhängigkeit der beobachteten Verstimmung Δ_{B}, so dass die Frequenzbänder f_{MW} ± f_{SB} auch nach erfolgter Verstimmung Δ_{B} im Bereich der bei dieser Verstimmung Δ_{B} vorliegenden Resonanzfrequenzen f_{±} der NV-Zentren bleibt;
wobei die Auswerteeinheit (4) zur Bestimmung des äußeren Magnetfeldes B aus dem Abstand 2*f_{SB} der beiden Frequenzbänder und der Verstimmung Δ_{B} vorgesehen ist.

12. Das NV-Magnetometer (1) nach Anspruch 11,
**dadurch gekennzeichnet,**
**dass** der Mikrowellensender (6) einen Signalgenerator (61) zur Erzeugung eines Signals mit der Mikrowellenfrequenz f_{MW} und einen weiterer Signalgenerator (62) zur Erzeugung eines frequenzmodulierten Signals mit der Trägerfrequenz f_{SB}, einer Modulationsfrequent fₘ und einer Modulationsamplitude f_{d} mit f_{SB}(t) = f_{SB} + f_{d} * cos(2πfₘt) mit t als der Zeit mit einer jeweiligen Leistung umfasst.

13. Das NV-Magnetometer (1) nach Anspruch 12,
**dadurch gekennzeichnet,**
**dass** die Signalgeneratoren (61, 62) dazu ausgestaltet sind, die Leistungen der Signale anzupassen oder die Signalgeneratoren (61, 62) zur individuellen Leistungsanpassung einen Abschwächer (7) vorgeschaltet haben.

14. Das NV-Magnetometer (1) nach einem der Ansprüche 11 bis 13,
**dadurch gekennzeichnet,**
**dass** das Sensormaterial (2) Diamant ist.

15. Verwendung eines oder mehrerer NV-Magnetometer nach einem der Ansprüche 11 bis 14 für gradiometrische Messungen.

## Claims

1. Method (100) for determining an outer magnetic field using an NV magnetometer (1) with automated resonance control, wherein the NV magnetometer (1) comprises a sensor material (2) having NV centers which have respective spin states mₛ = 0, ± 1 and resonance frequencies f_{±} for transitions between the spin states mₛ = 0 ↔ ± 1, wherein a difference f₊ - f₋ of the resonance frequencies f_{±} depends on the outer magnetic field B, comprising the following steps:
- recording (110) single-resonance signals V_{SR-LIA} to determine the resonance frequencies f_{±} by means of frequency-modulated microwave radiation irradiated onto the sensor material (2) in frequency bands based on a microwave frequency f_{MW} and a carrier frequency f_{SB}, wherein the microwave frequency f_{MW} and the carrier frequency f_{SB} are selected so that the frequency bands address the two magnetic resonances one after the other;
- recording (120) a demodulated double-resonance signal V_{DR-LIA} having a dispersive form and a linear region around the resonance frequencies f_{±}, wherein the microwave frequency f_{MW} and the carrier frequency f_{SB} are selected such that f_{MW} ± f_{SB} = f_{±} so that both magnetic resonances are excited simultaneously;
- determining (130) a slope of the linear region as a scalar factor α from the demodulated signal V_{DR-LIA};
- observing (140) a detuning Δ_{B} = V_{DR-LIA} /A of the resonance frequencies f_{±} via the demodulated signal V_{DR-LIA} in the case of resonant irradiation of microwave radiation due to outer magnetic field changes by means of an evaluation unit (4);
- controlling (150) the frequency bands f_{MW} ± f_{SB} using a controller (5) comprising a control algorithm on the basis of the observed detuning Δ_{B} so that even after the detuning Δ_{B} has taken place, the frequency bands f_{MW} ± f_{SB} remain in the region of the resonance frequencies f_{±} of the NV centers, which frequencies are present in the case of this detuning Δ_{B}; and
- determining (160) the outer magnetic field B from the distance 2*f_{SB} between the two frequency bands and from the detuning Δ_{B} by means of the evaluation unit (4).

2. Method (100) according to claim 1, wherein the controlling (150) comprises the following steps:
- comparing (152) the demodulated signal V _{DR-VIA} with a target value r = 0;
- calculating (154) a deviation e = r - V_{DR-LIA} = - V_{DR-LIA}; and
- shifting (156) the frequency bands of the microwave radiation in the opposite direction by Δf_{MW} by means of the controller (5).

3. Method (100) according to claim 2, wherein the controller (5) controls as an integral software-based controller (5) according to the regulation Δf_{MW}[n] = K * (e[0] + e[1] + .... + e[n] with K as a proportionality factor of the controller (5) where i = 0, 1, ... , n as iteration steps.

4. Method (100) according to claim 3, wherein the proportionality factor is K = 1/ α.

5. Method (100) according to any of the preceding claims, wherein the controller (5) has a control period Tc after which the microwave frequency f_{MW} is again controlled using the controller, wherein the control period Tc is between 1µs and 10s, preferably between 0.05s and 1s, more preferably 0.5s.

6. Method (100) according to any of the preceding claims, wherein a signal generator (61) generates a signal with the microwave frequency f_{MW} and another signal generator (62) generates a frequency-modulated signal with the carrier frequency f_{SB}, a modulation frequency fₘ and a modulation amplitude f_{d} with f_{SB}(t) = f_{SB} + f_{d} * cos(2πfₘt), with t being the time, at a relevant power.

7. Method (100) according to claim 6, wherein the two signals are frequency-mixed by means of a frequency mixer (9) and the microwave radiation radiated onto the sensor material (2) comprises the two frequency bands f_{MW} + f_{SB}(t) and f_{MW} - f_{SB}(t), wherein f_{SB}(t) in f_{MW} - f_{SB}(t) is phase-shifted by π.

8. Method (100) according to claim 7, wherein the microwave frequency f_{MW} and the carrier frequency f_{SB} are selected such that the two frequency bands are each resonant with the resonance frequencies f_{±}.

9. Method (100) according to any of claims 6 to 8, wherein the two frequency bands are radiated with individually set powers.

10. Method (100) according to claim 9, wherein the powers are individually set by means of a programmable attenuator (7) or by adjusting the power of the signal generators (61, 62).

11. NV magnetometer (1) for determining an outer magnetic field B designed to carry out a method (100) for automated resonance control according to any of the preceding claims, comprising
- a sensor material (2) having NV centers which have respective spin states mₛ = 0, ± 1 and resonance frequencies f_{±} for transitions between the spin states mₛ = 0 ↔ ± 1, wherein a difference f₊ - f₋ of the resonance frequencies f_{±} depends on the outer magnetic field B,
- a microwave transmitter (6) for exciting magnetic resonances at the resonance frequencies f_{±} by means of frequency-modulated microwave radiation irradiated onto the sensor material (2) in frequency bands based on a microwave frequency f_{MW} and a carrier frequency f_{SB}; wherein the microwave frequency f_{MW} and the carrier frequency f_{SB} are selected for recording single-resonance signals V_{SR-LIA} such that the frequency bands address the two magnetic resonances sequentially, and wherein the microwave frequency f_{MW} and the carrier frequency f_{SB} are selected for recording a demodulated double-resonance signal V_{DR-LIA} such that f_{MW} ± f_{SB} = f_{±} so that the two magnetic resonances are excited simultaneously;
- a laser (11) for emitting a continuous wave mode with a wavelength in the range of 510 - 540 nm for continuous initialization and readout of the spin states,
- a suitable detector (8), preferably an optical detector, for recording frequency-modulated fluorescence light from the sensor material (2);
- a lock-in amplifier (3) for demodulating the fluorescence light, wherein, upon excitation of one or both magnetic resonances, the signals V_{SR-LIA} or V_{DR-LIA} result with a dispersive form and a linear region around the resonance frequencies f_{±};
- an evaluation unit (4) for observing the DETUNING Δ_{B} = V_{DR-LIA} /A of the resonance frequencies f_{±} via the demodulated signal V_{DR-LIA};
- a controller (5) for controlling the frequency bands f_{MW} ± f_{SB} using a control algorithm on the basis of the observed detuning Δ_{B} so that even after the detuning Δ_{B} has taken place, the frequency bands f_{MW} ± f_{SB} remain in the region of the resonance frequencies f_{±} of the NV centers, which resonance frequencies are present in the case of this detuning Δ_{B};
wherein the evaluation unit (4) is intended to determine the outer magnetic field B from the distance 2*f_{SB} between the two frequency bands and the detuning ΔB.

12. NV magnetometer (1) according to claim 11,
**characterized in that**
the microwave transmitter (6) comprises a signal generator (61) for generating a signal with the microwave frequency f_{MW} and a further signal generator (62) for generating a frequency-modulated signal with the carrier frequency f_{SB}, a modulation frequency fₘ and a modulation amplitude f_{d} with f_{SB}(t) = f_{SB} + f_{d} * cos(2πtfₘt), with t being the time, at a relevant power.

13. NV magnetometer (1) according to claim 12,
**characterized in that**
the signal generators (61, 62) are designed to adjust the power of the signals or the signal generators (61, 62) have an attenuator (7) connected upstream for individual power adjustment.

14. NV magnetometer (1) according to any of claims 11 to 13,
**characterized in that**
the sensor material (2) is diamond.

15. Use of one or more NV magnetometers according to any of claims 11 to 14 for gradiometric measurements.

## Revendications

1. Un procédé (100) pour déterminer un champ magnétique extérieur à l'aide d'un magnétomètre NV (1) avec régulation de résonance automatisée, le magnétomètre NV (1) comprenant un matériau capteur (2) avec des centres NV ayant des états de spin mₛ = 0, ± 1 et des fréquences de résonance f± pour les transitions entre les états de spin mₛ = 0 ↔ ± 1 comprend, dont la différence f+ - f- des fréquences de résonance f± dépend du champ magnétique extérieur B, comprenant les étapes suivantes :
- Enregistrement (110) de signaux de résonance simples V_{SR-LIA} pour la détermination des fréquences de résonance f± par le rayonnement micro-ondes modulé en fréquence irradié sur le matériau capteur (2) dans des bandes de fréquence basées sur une fréquence micro-ondes f_{MW} et une fréquence porteuse f_{SB}, les fréquences micro-ondes f_{MW} et la fréquence porteuse f_{SB} étant choisies de sorte que les bandes de fréquence adressent successivement les deux résonances magnétiques ;
- Enregistrement (120) d'un signal de double résonance démodulé V_{DR-LIA} de forme dispersive et présentant une zone linéaire autour des fréquences de résonance f_{±}, les fréquences micro-ondes f_{MW} et la fréquence porteuse f_{SB} étant choisies de sorte que f_{MW} ± f_{SB} = f_{±}, de sorte que les deux résonances magnétiques sont excitées simultanément ;
- Détermination (130) d'une pente de la zone linéaire comme facteur scalaire a à partir du signal démodulé V_{DR-LIA} ;
- Observation (140) d'un déplacement ΔB = V_{DR-LIA} /α des fréquences de résonance f± via le signal démodulé V_{DR-LIA} lors de l'irradiation micro-ondes en résonance, dû à des variations du champ magnétique externe, au moyen d'une unité d'évaluation (4) ;
- Régulation (150) des bandes de fréquence f_{MW} ± f_{SB} à l'aide d'un régulateur (5) comprenant un algorithme de régulation dépendant du déplacement observé ΔB, de sorte que les bandes de fréquence f_{MW} ± f_{SB} restent, même après survenue du déplacement ΔB, dans la plage des +fréquences de résonance f_{±} des centres NV ; et
- Détermination (160) du champ magnétique externe B à partir de la distance 2*f_{SB} des deux bandes de fréquence et du déplacement ΔB au moyen de l'unité d'évaluation (4).

2. Le procédé (100) selon la revendication 1, dans lequel la régulation (150) comprend les étapes suivantes :
- Comparaison (152) du signal démodulé V_{DR-LIA} à une valeur de consigne r = 0 ;
- Calcul (154) d'un écart e = r - V_{DR-LIA} = V_{DR-LIA} ; et
- Déplacement (156) des bandes de fréquence du rayonnement micro-ondes dans des directions opposées de Δf_{MW} au moyen du régulateur (5).

3. Le procédé (100) selon la revendication 2, dans lequel le régulateur (5) en tant que régulateur intégral logiciel (5) selon la règle Δf_{MW}[n] = K * (e[0] + e[1] + ... + e[n]), K étant le facteur de proportionnalité du régulateur (5) et i = 0, 1, ..., n comme étapes d'itération.

4. Le procédé (100) selon la revendication 3, dans lequel le facteur de proportionnalité K = 1/α.

5. Le procédé (100) selon l'une quelconque des revendications précédentes, dans lequel le régulateur (5) possède une période de régulation Tc, après laquelle la fréquence micro-ondes f_{MW} est de nouveau réglée par le régulateur, la période de régulation Tc étant comprise entre 1µs et 10s, de préférence entre 0,05s et 1s, encore préférentiellement 0,5s.

6. Le procédé (100) selon l'une quelconque des revendications précédentes, dans lequel un générateur de signal (61) génère un signal avec la fréquence micro-ondes f_{MW} et un autre générateur de signal (62) un signal modulé en fréquence avec la fréquence porteuse f_{SB}, une fréquence de modulation fₘ et une amplitude de modulation f_{d} avec f_{SB}(t) = f_{SB} + f_{d} * cos(2πfₘt) avec t comme le temps, générés avec une puissance respective.

7. Le procédé (100) selon la revendication 6, dans lequel les deux signaux sont mélangés en fréquence au moyen d'un mélangeur de fréquences (9) et le rayonnement micro-ondes dirigé vers le matériau capteur (2) comprend les deux bandes de fréquence f_{MW} + f_{SB}(t) et f_{MW} - f_{SB}(t), f_{SB}(t) associée à f_{MW} - f_{SB}(t) est déphasée de π .

8. Le procédé (100) selon la revendication 7, dans lequel la fréquence micro-ondes f_{MW} et la fréquence porteuse f_{SB} sont choisies de sorte que les deux bandes de fréquence soient respectivement résonantes avec les fréquences de résonance f_{±}.

9. Le procédé (100) selon l'une quelconque des revendications 6 à 8, dans lequel les deux bandes de fréquence sont émises avec des puissances réglées individuellement.

10. Le procédé (100) selon la revendication 9, dans lequel les puissances sont réglées individuellement au moyen d'un atténuateur programmable (7) ou en ajustant la puissance des générateurs de signal (61, 62).

11. Un magnétomètre NV (1) destiné à la détermination d'un champ magnétique externe B, conçu pour l'exécution d'un procédé (100) de régulation de résonance automatisée selon l'une des revendications précédentes, comprenant :
- un matériau capteur (2) avec des centres NV avec des états de spin respectifs mₛ = 0, ↔ ± 1 et des fréquences de résonance f_{±} pour des transitions entre les états de spin mₛ = 0 ↔ ± 1, où une différence f₊ - f₋ des fréquences de résonance f_{±} dépend du champ magnétique externe B,
- un émetteur micro-ondes (6) pour exciter des résonances magnétiques aux fréquences de résonance f_{±} au moyen d'un rayonnement micro-ondes modulé en fréquence dirigé sur le matériau capteur (2) dans des bandes de fréquence basées sur une fréquence micro-ondes f_{MW} et une fréquence porteuse f_{SB} ; où la fréquence micro-ondes f_{MW} et la fréquence porteuse f_{SB} sont choisies pour l'enregistrement de signaux de résonance simples V_{SR-LIA} de sorte que les bandes de fréquence adressent successivement les deux résonances magnétiques, et où la fréquence micro-ondes f_{MW} et la fréquence porteuse f_{SB} sont choisies pour l'enregistrement d'un signal de double résonance démodulé V_{DR-LIA} de sorte que f_{MW} ± f_{SB} = f_{±}, de sorte que les deux résonances magnétiques sont excitées simultanément ;
- un laser (11) pour l'émission en fonctionnement continu avec une longueur d'onde dans la plage de 510 - 540 nm pour l'initialisation et la lecture continues des états de spin,
- un détecteur approprié (8), de préférence un détecteur optique, pour la détection de la fluorescence modulée en fréquence du matériau capteur (2) ; un amplificateur Lock-in (3) pour la démodulation de la fluorescence, où, lors de l'excitation d'une ou des deux magnétorésonances, les signaux V_{SR-LIA} ou V_{DR-LIA} présentent une forme dispersive et une zone linéaire autour des fréquences de résonance f_{±} ;
- une unité d'évaluation (4) pour l'observation du décalage ΔB = V_{DR-LIA} /α des fréquences de résonance f_{±} via le signal démodulé V_{DR-LIA} ;
- un régulateur (5) pour la régulation des bandes de fréquence f_{MW} ± f_{SB} avec un algorithme de régulation en fonction du déplacement observé ΔB, de sorte que les bandes de fréquence f_{MW} ± f_{SB} restent également après survenue du déplacement *L1B* dans la plage des fréquences de résonance f_{±} des centres NV ;
où l'unité d'évaluation (4) est prévue pour la détermination du champ magnétique externe B à partir de l'écart 2*f_{SB} des deux bandes de fréquence et du décalage ΔB.

12. Le magnétomètre NV (1) selon la revendication 11, **caractérisé, en ce que** l'émetteur micro-ondes (6) comprend un générateur de signal (61) pour la génération d'un signal avec la fréquence micro-ondes f_{MW} et un autre générateur de signal (62) pour la génération d'un signal modulé en fréquence avec la fréquence porteuse f_{SB}, une fréquence de modulation fm et une amplitude de modulation f_{d} avec f_{SB}(t) = f_{SB} + f_{d} * cos(2πfₘt) avec t comme le temps, générés avec une puissance respective.

13. Le magnétomètre NV (1) selon la revendication 12, **caractérisé en ce que**, les générateurs de signal (61, 62) sont conçus pour ajuster les puissances des signaux, ou que les générateurs de signal (61, 62) sont précédés d'un atténuateur programmable (7) pour un réglage individuel de la puissance.

14. Le magnétomètre NV (1) selon l'une quelconque des revendications 11 à 13, **caractérisé en ce que** le matériau capteur (2) est du diamant.

15. Utilisation d'un ou de plusieurs magnétomètres NV selon l'une quelconque des revendications 11 à 14 pour des mesures gradiométriques.
